# EUROPEAN PATENT APPLICATION

(11) **EP 2 234 172 A1**
(43) Date of publication of application: **29.09.2010**
(21) Application number: 09702907.8
(22) Date of filing: 14.01.2009
(51) Int. Cl.: H01L 31/042

(54) **SOLAR CELL MODULE AND METHOD FOR MANUFACTURING THE SAME**

(30) Priority: 15.01.2008 JP 2008029640; 03.04.2008 JP 2008120015; 28.05.2008 JP 2008163801; 28.10.2008 JP 2008298746
(71) Applicant: Affinity Co., Ltd., Nakano-ku, Tokyo 165-0025 (JP)
(72) Inventor: WATANABE, Haruo, Tokyo 165-0025 (JP)
(74) Representative: HOFFMANN EITLE
(86) International application number: PCT/JP2009/050787
(87) International publication number: WO 2009/091068

(57) **Abstract**

An ultrahigh durability solar cell module that can be used semi-permanently, with an ultrahigh durability transparent substrate, solar cell element and filler, wherein the solar cell element and a liquid substance or a gel obtained by reacting the liquid substance as the filler, are sealed by a fast sealed structure comprising a high durability crosslinking reactive adhesive provided between a glass panel and back side protective substrate, and a hot-melt adhesive. The module is produced by placing the sealing compound, solar cell element and liquid substance on the glass panel and finally laying the back side protective substrate to form a provisional laminated body, and then compression bonding the provisional laminated body at room temperature in a vacuum for sealing.

## Description

### Technical Field

The present invention relates to a solar cell module obtained by laminating a transparent substrate and a back side protective substrate with a solar cell element (photoelectric conversion element) between them via a filler, as well as to a process for its production.

### Background Art

High conversion efficiency, high durability and low cost have been desired for solar cells in recent years. The conversion efficiency depends on the element characteristics of the solar cell, but the actual performance largely depends on the durability of the solar cell module. There is in fact a demand for solar cell modules that can be used semi-permanently while maintaining their initial high conversion efficiency. Solar cell elements such as plate crystal elements, spherical crystal elements and thin-film elements undergo some changes in properties under solar irradiation, but fundamentally they are stable members composed of inorganic materials. The present inventors therefore focused on the durability of materials used to form modules from such elements.

The fillers widely used in large-area solar cell modules are mainly ethylene/vinyl acetate copolymer (hereinafter referred to as "EVA") resin sheets. When used, the cut EVA sheet is situated between the substrates together with the element and, after hot fusion in a vacuum, it is compression bonded and then subjected to further heat treatment for crosslinking reaction. As a result, many problems have been noted including slowed production speed due to the vacuum heat treatment, generation of corrosive gas during the heat treatment, and the need for removal of resin that seeps from the edges and moisture-proof treatment of the edges. The details regarding modules are described in "Solar Photovoltaic Power Generation" (Hamakawa, Y. ed., CMC Publishing) and will not be discussed here.

Prior art similar to the invention will now be described. Potting is a method in which a silicone-based liquid substance is cast into a concave box and gelled, and a plate crystal element is packed into it. Another method involves laminating a plate crystal element between small substrates via a silicone-based liquid substance, and then gelling the substance and removing the excess seeping gel. However, these methods have not been applicable for large-area modules. Other methods exist in which a solar cell element is attached to a glass panel and gaps and injection holes are provided to anchor the opposing substrates with double-sided adhesive tape, after which an acrylic liquid substance is cast into the injection holes, but such methods are associated with problems such as residue of air bubbles, protruding lead wires that must be processed, and insufficient long-term durability.

Patent document 1 (Japanese Unexamined Patent Publication No. 2003-101058) proposes a module comprising a liquid substance encapsulated as a bag for easy recycling. This has a packed structure wherein the base material is sealed by thermocompression bonding without special provision of a sealing compound. With this manner of sealing, however, bonding with lead wires is not sufficient, liquid leakage tends to occur more easily, and durability is also a problem. In addition, the liquid substance wraps around during thermocompression bonding, making it difficult to produce a module without gas bubbles.

Patent document 2 (Japanese Unexamined Patent Publication No. 2005-101033) proposes encapsulating a liquid substance as a filler between plastic substrates, in order to prevent breakage of interconnectors. However, sealing of the outer peripheral sections, which are most essential for durability, is not specifically discussed and only welding (thermocompression bonding) or adhesives are mentioned. In addition, it nowhere discusses a method for gas bubble-free lamination and processing of protruding lead wires, which are essential when using liquid substances as fillers. Only liquid substances such as liquid paraffins and silicone oils, however, are given as examples of fillers.

Patent document 3 (Japanese Unexamined Patent Publication HEI No. 8-88388) proposes a process for production of a module obtained by laminating an individual film such as EVA as a filler between film substrates and then coating the outer periphery with a hot-melt adhesive and thermocompression bonding the laminate for sealing, for the purpose of obtaining a simple module without an aluminum frame. However, this employs a complex two-stage process involving separate thermocompression bonding of the filler and sealing compound, and it has been difficult to accomplish lamination without gas bubbles by such simple thermocompression bonding of the outer periphery.

The methods proposed in Patent documents 1, 2 and 3 assume the use of plastic plates as substrates, and thus differ from the present invention which is concerned with ultrahigh durability. It is also difficult, using these prior art methods, to accomplish lamination of fillers in a gas bubble-free state, which is necessary for electrical components. In addition, it is difficult to obtain high durability modules that can be used for prolonged periods in outdoor environments.

In conventional large-area modules, multiple plate crystal elements (thickness: about 0.05-0.3 mm) are connected by interconnectors to form a module via EVA, in order to increase the generation efficiency to between several tens and several 100 W. The molecular structure of EVA is a hydrocarbon-based polymer with ester bonds (hydrophilic functional groups), and improvements have been achieved by addition of ultraviolet absorbers, antioxidants and the like, but nevertheless, prolonged sun exposure for periods of about 20 years causes deterioration of the resin including peeling, whitening and yellowing, and hence reduced transmittance of sunlight rays which results in lower generation efficiency year-by-year. Also, thin-film elements are formed directly on glass panels for the most part, and they are significantly affected by moisture, making it problematic to use EVA as a filler. The use of polyvinyl butyral has also been investigated, but it has proven to have the same problems of durability as EVA.

### Disclosure of the Invention

The present inventors therefore, considering that solar cell modules are used under harsh conditions, being fully irradiated with sunlight for very long periods in an outdoor environment, examined them with the precondition of using a material that is resistant to deterioration and capable of semi-permanent use. As a result, we discovered a method of using a liquid substance as the filler or as the starting substance therefor and carrying out high-speed lamination at room temperature, and developed an innovative solar cell module capable of semi-permanent use and a process for its production.

In other words, the present invention provides an ultrahigh durable solar cell module that can be used outdoors semi-permanently while maintaining high conversion efficiency which is important for a solar cell, as well as a process that allows it to be produced at low cost.

In order to solve the problems mentioned above, the invention encompasses the following aspects.
1. A solar cell module having a photoelectric conversion thin-film element or crystal element situated between a transparent substrate and a back side protective substrate, with a filler situated surrounding the element and the outer periphery sealed with a sealing compound, the solar cell module being **characterized in that** the transparent substrate is a glass panel, the filler is a silicone-based liquid substance, fluorine oil or silicone gel, the sealing compound is composed of a crosslinking reactive adhesive, both substrates are adhesively anchored in contact with the outer periphery of the filler, the sections of the lead wires that protrude from the element, which penetrate the sealing compound on the outer periphery, are bonded with the sealing compound and are adhesively anchored between both substrates, and the filler and element are sealed between both substrates together with the sealing compound.
2. A solar cell module according to 1 above, wherein the crosslinking reactive adhesive is a silicone-based resin adhesive.
3. A solar cell module according to 1 or 2 above, wherein an isobutylene-based resin bonding agent is formed at the outer periphery between the substrates in such a manner that it contacts the crosslinking reactive adhesive.
4. A process for production of a solar cell module according to 1 above, the process being **characterized in that** a photoelectric conversion thin-film element or crystal element is situated on either a glass panel or a back side protective substrate, a crosslinking reactive adhesive is situated as a sealing compound at the outer periphery sections of the lead wires extending from the outer periphery of the substrate and the element, a silicone-based liquid substance or fluorine oil is situated as a filler, another glass panel or back side protective substrate is laminated thereover, the filler and element are pressure laminated between both substrates in a vacuum state together with the crosslinking reactive adhesive situated around their outer periphery, to form a laminated body, and then the crosslinking reactive adhesive is crosslinked.
5. A process for production of a solar cell module according to 4 above, wherein the laminated body is formed by pressure lamination after placing an isobutylene-based resin bonding agent adjacent to the crosslinking reactive adhesive, to additionally form an isobutylene-based resin bonding agent layer between the substrates.
6. A process for production of a solar cell module according to 4 or 5 above, wherein after lamination a silicone-based liquid substance is reacted to form a silicone gel.
7. A solar cell module having a photoelectric conversion crystal element situated between a transparent substrate and a back side protective substrate, with a filler situated surrounding the element and the outer periphery sealed with a sealing compound, the solar cell module being **characterized in that** the transparent substrate is a glass panel, the filler is a silicone gel, the sealing compound is composed of an isobutylene-based resin bonding agent, both substrates are adhesively anchored in contact with the outer periphery of the filler, the sections of the lead wires that protrude from the element, which penetrate the sealing compound on the outer periphery, are bonded with the sealing compound and are adhesively anchored between both substrates, and the filler and element are sealed between both substrates together with the sealing compound.
8. A process for production of a solar cell module according to 7 above, the process being **characterized in that** a crystal element is situated on either a glass panel or a back side protective substrate, an isobutylene-based resin bonding agent is situated as a sealing compound at the outer periphery sections of the lead wires extending from the outer periphery of the substrate and the element, a silicone-based liquid substance is situated as a filler, another glass panel or back side protective substrate is laminated thereover, the filler and element are pressure laminated between both substrates in a vacuum state together with the isobutylene-based resin bonding agent around their outer periphery, to form a laminated body, and then the silicone-based liquid substance is reacted to form a silicone gel.
9. A solar cell module having a photoelectric conversion thin-film element situated between a transparent substrate and a back side protective substrate, with a filler situated surrounding the element and the outer periphery sealed with a sealing compound, the solar cell module being **characterized in that** the transparent substrate is a glass panel, the filler is a silicone gel, the sealing compound is composed of an isobutylene-based resin bonding agent, both substrates are adhesively anchored in contact with the outer periphery of the filler, the sections of the lead wires that protrude from the element, which penetrate the sealing compound on the outer periphery, are bonded with the sealing compound and adhesively anchored between both substrates, and the filler and element are sealed between both substrates together with the sealing compound.
10. A process for production of a solar cell module according to 9 above, the process being **characterized in that** an isobutylene-based resin bonding agent is situated as a sealing compound at the outer periphery sections of the lead wires extending from the outer periphery of a glass panel on which a photoelectric conversion thin-film element is formed, and the element, while a silicone-based liquid substance is situated as a filler, a back side protective substrate is laminated thereover, the filler and element are pressure laminated between both substrates in a vacuum state together with the isobutylene-based resin bonding agent around their outer periphery, to form a laminated body, and then the silicone-based liquid substance is reacted to form a silicone gel.

According to the invention it is possible to provide an ultrahigh durable solar cell module that has high conversion efficiency and can be used outdoors semi-permanently.

### Brief Description of the Drawings

Fig. 1 is a cross-sectional view showing an example of the laminated structure and the protruding section of a lead wire, in a solar cell module according to the invention.
Fig. 2 is a cross-sectional view showing another example of the laminated structure in a solar cell module according to the invention.
Fig. 3 is a cross-sectional view showing another example of the laminated structure in a solar cell module according to the invention.
Fig. 4 is a cross-sectional view showing another example of the laminated structure in a solar cell module according to the invention.
Fig. 5 is a cross-sectional view showing another example of the laminated structure in a solar cell module according to the invention.
Fig. 6 is a cross-sectional view showing another example of the laminated structure in a solar cell module according to the invention.
Fig. 7 is a cross-sectional view showing another example of the protruding section of a lead wire, in a solar cell module according to the invention.
Fig. 8 is a cross-sectional view showing another example of the protruding section of a lead wire, in a solar cell module according to the invention.

### Best Mode for Carrying Out the Invention

The present inventors recognized that in order to obtain an ultrahigh durability solar cell module it is essential for at least the transparent substrate, solar cell element and filler to be made of semi-permanent materials. A glass panel is a stable transparent substrate. Because the plate crystal element and thin-film element are made of inorganic materials, the solar cell element of the invention can be utilized for prolonged periods, although some differences will exist between individual elements. As a result of further basic research on fillers, the present inventors have discovered a method for gas bubble-free sealing of ultrahigh durable liquid substances (for example, silicone oil or silicone gel) between substrates with a powerfully sealed structure (for example, using a silicone-based resin adhesive or the like), and have completed an ultrahigh durable solar cell module. Furthermore, by using a glass panel as the back side protective substrate, we succeeded in obtaining an innovative solar cell module with even greater durability. The provision of such an ultrahigh durability solar cell module is highly significant in terms of energy recovery, resource saving and economy.

Numerous types of photoelectric conversion elements for solar cells exist, which are thin-film elements having elements formed on substrates, including crystal elements (plate crystal elements and spherical crystal elements) such as single crystal silicon elements and polycrystal silicon elements, or amorphous silicon thin-film elements, microcrystalline silicon thin-film elements or CIGS-based thin-film elements, as well as hybrid-type elements obtained by laminating thin-film elements on plate crystal elements, and these may all by utilized for the invention. Plate crystal elements and thin-film elements will be described in detail below, but spherical crystal elements are also encompassed within the scope of the invention.

The invention can solve all of the aforementioned problems considered essential to improve conventional EVA processes. The invention constitutes the first successful construction of a secure sealed structure that reliably prevents leakage of liquid substances, even at the protruding sections of lead wires that are most troublesome. It is thus possible to obtain an ultrahigh durable module with absolutely no gas bubbles (critical defects in electrical components) or liquid leakage (defective modules). In addition, application of the sealing compound and filler can be accomplished by a simple coating step, while easily matching various sizes from small to large sizes and various shapes (for example, rectangular, triangular, trapezoid, circular, etc.). Specifically, the sealing compound is placed on the outer periphery of the glass panel and the plate crystal element (the thin-film element already having been formed on the glass panel side) is situated thereover, additional sealing compound is placed on the upper side of the protruding sections of the lead wires, the liquid substance to be used as the filler is dropped thereon, spacers are situated if necessary and the back side protective substrate is stacked to form a provisional laminated body, and then the provisional laminated body is vacuum deaerated with a vacuum laminating apparatus and subsequently compression bonded at room temperature to form a laminated body. The essential aspect of this process is that during the compression in a vacuum at room temperature, the highly viscous sealing compound is squeezed while it maintains its position of placement at the outer periphery and becomes bonded between the two substrates, while also functioning as a bank to prevent liquid leakage of the liquid substance. This method is therefore innovative since it accomplishes lamination simply by room temperature pressurizing treatment in a vacuum for a brief period of about 2-3 minutes, and standing in a normal state.

In the following detailed explanation, silicone oil is used as an example of the liquid substance, but this is not intended to be limitative. Silicone oil has a flow property in a wide temperature range of -70°C to 300°C, and it satisfies the requirements of transparency, heat resistance, cold resistance, water resistance, insulation and weather resistance. The silicone-based liquid substance may also undergo reaction after the lamination to form a non-fluid material such as a gel.

According to the invention, "gel" refers to a non-fluid filler formed by reaction of the liquid substance after lamination (gel, elastomer or the like).

The sealed structure with the sealed liquid substance, and the sealing compound used, will now be explained. The sealing compound must exhibit both a bank function to prevent liquid leakage of the liquid substance during lamination and an adhesive function to stably anchor both substrates. Specifically, there may be used one sealing compound with both functions or two different sealing compounds exhibiting the two different functions. When the liquid substance is subjected to crosslinking reaction after lamination to form a gel, a sealing compound exhibiting a bank function may be used alone. In such cases the liquid substance will be non-fluid and liquid leakage will not occur. High durability is, of course, necessary for the adhesive function in particular. Examples include highly viscous silicone-based resin adhesives (crosslinking reactive adhesives) exhibiting both functions, and ultra-highly viscous isobutylene-based resin bonding agents (hot-melt adhesives) exhibiting a bank function.

Solar cell elements include both plate crystal elements and thin-film elements, and it is necessary to take into account the large difference in thicknesses of such elements. Module structures comprising elements (a plate crystal element and thin-film element), fillers (a silicone oil and silicone gel) and sealing compounds (a silicone-based resin adhesive and isobutylene-based resin bonding agent) will now be described as concrete examples.

While it is preferred to use a glass panel as the back side protective substrate from the viewpoint of ultrahigh durability, a resin sheet or resin panel may be used instead for lighter weight. The spacers are not shown in the drawings.

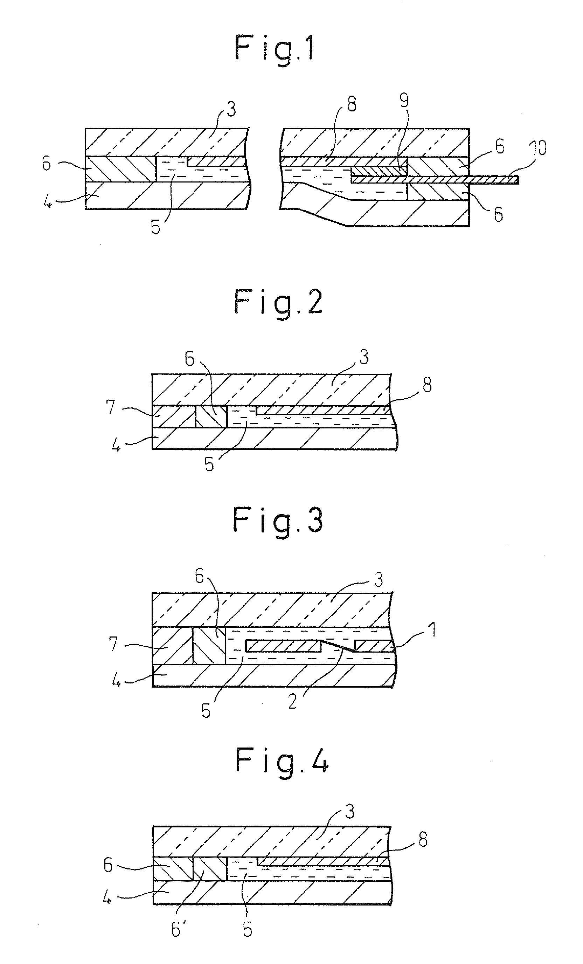

Fig. 1 shows the cross-sectional structure of a module obtained by laminating a thin-film element 8 on one side of a glass panel 3. The silicone oil as the filler 5 is sealed using a silicone-based resin adhesive as the first sealant 6 provided between the glass panel 3 and back side protective substrate 4. A lead wire 10 protrudes, being connected to the thin-film element 8 by a joint 9 composed of a conductive bonding agent (for example, solder or silver paste). The silicone-based resin adhesive of the first sealant 6 is also situated above and below the protruding section of the lead wire 10, and the glass panel 3, back side protective substrate 4 and lead wire 10 are adhesively anchored. The lamination may be performed with an excess of the silicone-based resin adhesive to fully cover the joint 9. However, the spacing between the substrates at the joint will be increased by the lead wire 10. In addition, the thin-film element 8 is preferably situated outside of the region of the outer periphery, as shown in the drawing, in order to accomplish satisfactory adhesion and bonding of the sealing compound with the glass panel 3. After lamination, the liquid substance may be reacted for conversion to a silicone gel. Silicone-based resin adhesives are known to have high weather resistance. A module wherein the back side protective substrate 4 is also a glass panel can be used for windows, eaves and atriums, with the same high durability and designability as conventional window glass. Also, a glass panel may be added to provide a gas layer, for window glass with a thermal insulation property.

Fig. 2 shows the cross-sectional structure of a module obtained by laminating a thin-film element 8. The thin-film element 8 is affected by moisture, and in some cases the silicone-based resin adhesive of the first sealant 6 will transmit water molecules. Therefore, providing a layer of an isobutylene-based resin bonding agent as a second sealant 7 can greatly reduce the moisture permeability and is advantageous for use in high temperature, high humidity regions. The first sealant 6 may be placed on the outside of the second sealant 7 or on both sides thereof, and a two-stage, 4-layer sealing structure may also be formed. If both substrates are glass panels it is possible to obtain ultrahigh durability without providing an aluminum frame in the module, thus providing benefits in terms of low cost, lightning strike prevention and contaminant residue prevention, to increase utility for large-scale solar photovoltaic power generation in the field.

Fig. 3 shows the cross-sectional structure of a module obtained by laminating a plate crystal element 1. The plate crystal element 1 is connected by an interconnector 2, and laminated so that it is embedded in the silicone oil (fluid) or silicone gel (non-fluid) of the filler 5 between the glass panel 3 serving as the receiving surface and the back side protective substrate 4. The second sealant 7 is an isobutylene-based resin bonding agent that has ultrahigh viscosity and bonds with cohesion to the outer periphery to exhibit a bank function that reliably prevents liquid leakage. However, it has no adhesive force to adhesively anchor the two substrates and cannot hold up the weight of the silicone oil. Therefore, this stagewise sealing using the silicone-based resin adhesive of the first sealant 6 can prevent liquid leakage due to flow-down of the silicone oil, thus allowing a satisfactory module to be obtained. After lamination, the liquid substance may be reacted for conversion to a silicone gel. The isobutylene-based resin bonding agent is moisture-proof and prevents corrosion of the electrodes.

Fig. 4 shows the cross-sectional structure of a module obtained by laminating a thin-film element 8. The sealing structure incorporates a modification to the construction of the silicone-based resin adhesive in the first sealant 6 shown in Fig. 1. The sealant is composed of two different silicone-based resin adhesives, with a highly viscous silicone-based resin adhesive, having a greater viscosity than the other silicone-based resin adhesive, situated as an additional first sealant 6' to provide a bank function. The positions of the first sealant 6 and the additional first sealant 6' may optionally be reversed. Though not shown here, the construction may be utilized in a module employing the plate crystal element 1.

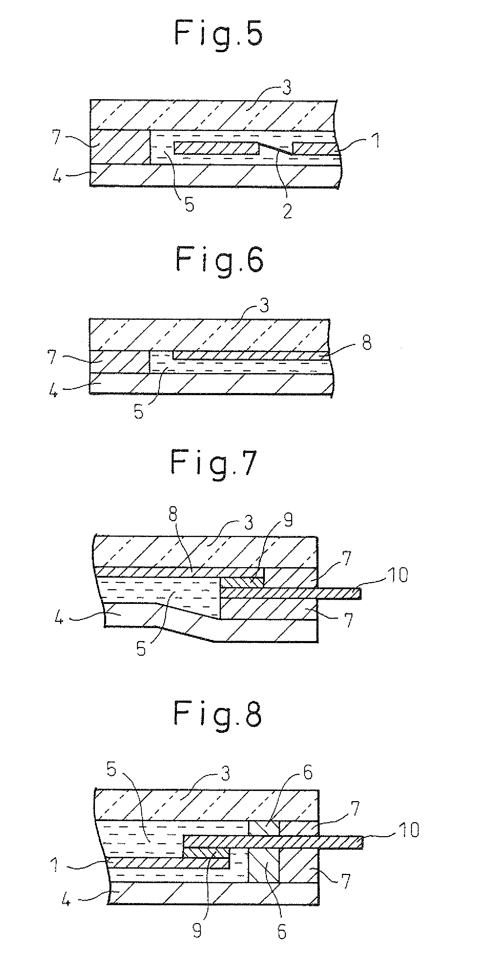

Fig. 5 shows the cross-sectional structure of a module obtained by laminating a plate crystal element 1. The isobutylene-based resin bonding agent of the second sealant 7 bonds with cohesion to the outer periphery to exhibit a bank function that reliably prevents liquid leakage. However, since both substrates are not adhesively anchored in this sealing structure, the liquid substance may be reacted after lamination to form a silicone gel (non-fluid) of the filler 5 in order to prevent liquid leakage of the liquid substance after lamination. Also, while not shown here, the silicone-based resin adhesive may be situated partially at the protruding section of the lead wire, as an additional modification, to adhesively anchor the lead wire and substrate and thus prevent shaking of the lead wire. In addition, a silicone-based resin adhesive may be spotted between the plate crystal element 1 and back side protective substrate 4 to anchor the plate crystal element 1.

Fig. 6 shows the cross-sectional structure of a module obtained with lamination of a thin-film element 8. Similar to Fig. 5, the second sealant 7 is an isobutylene-based resin bonding agent and the filler 5 is a silicone gel. As shown in Fig. 7, the lead wire 10 is connected and anchored to the thin-film element 8 by solder or the like at the joint 9.

The present invention will now be explained in greater detail. The solar cell element comprises a plate crystal element 1 and a thin-film element 8. The plate crystal element 1 connected by the interconnector 2 is laminated between the glass panel 3 and back side protective substrate 4, via the silicone oil of the filler 5 which is in a thin gas bubble-free state. Such a module structure has become possible for the first time by the production process of the invention wherein silicone oil is sealed in a vacuum.

The spacing between the substrates in the module is increased with a plate crystal element 1 and decreased with a thin-film element 8. The thickness of the plate crystal element 1 is about 0.05-0.2 mm, and the thin-film element 8 is extremely thin and can be considered integral with the glass panel. In the case of a plate crystal element, the spacing between the substrates is even thicker between of the connection with the interconnector 2, and the substrate spacing may be from about 0.1 mm to 3 mm, preferably from about 0.2 mm to 1.5 mm and more preferably from about 0.3 mm to 0.8 mm. In the case of a thin-film element, it is from about 0.005 mm to 3 mm, preferably from about 0.02 to 1 mm and even more preferably from about 0.05 to 0.5 mm. There is no particular advantage to a thicker spacing, while a smaller thickness is economical because it is lighter and requires less filler.

The sealing width will differ depending on whether a silicone-based resin adhesive is used alone or a combination of a silicone-based resin adhesive and isobutylene-based resin bonding agent is used, but in either case it may be about 2 mm-50 mm, preferably about 5 mm-30 mm and even more preferably about 8 mm-20 mm. When an isobutylene-based resin bonding agent is used alone, it may be about 2 mm-30 mm, preferably about 3 mm-15 mm and even more preferably about 5 mm-10 mm. Naturally, a wider sealing width at the outer periphery will decrease the light receiving area, and will thus affect the electric power generation.

Also, while not shown in the drawings, a flexible thin-film element, spherical crystal element or the like obtained by forming a thin-film element on a special sheet (for example, a polyimide sheet or stainless steel sheet) can be used in the module structure and production process described above, similar to using a plate crystal element, and such modes are also encompassed within the scope of the invention.

The production process of the invention will now be explained based on the structure shown in Fig. 3 with lamination of a plate crystal element 1. A band-shaped isobutylene-based resin bonding agent (which readily deforms like clay under pressure at room temperature and bonds to the substrate) is placed around the outer periphery approximately 3 mm in from the edge of the glass panel 3, and a two-pack mixed silicone-based resin adhesive (which undergoes curing reaction at room temperature and adhesively anchors both substrates) is further placed in a thin line fashion about 1 mm inward. Also, silicone oil is dropped onto it essentially uniformly and the plate crystal element 1 connected to an interconnector 2 is placed thereover, while the isobutylene-based resin bonding agent and silicone-based resin adhesive are also situated partially on the top side of the lead wire section and if necessary silicone oil is dropped onto the plate crystal element 1. Next, the back side protective substrate 4 is laminated to form a provisional laminated body.

The provisional laminated body is placed in a vacuum laminating apparatus at room temperature and subjected to deaeration under reduced pressure and then gentle compression in a vacuum state (0.7-1.0 Torr). As a result, the substrates become firmly bonded and sealed by the ultrahigh viscosity isobutylene-based resin bonding agent, in a short period of time. When the bonded laminated body is allowed to stand at atmospheric pressure, the interior is brought to negative pressure and is naturally compressed by atmospheric pressure, causing the sealing compound to be crushed flat while the low-viscosity silicone oil gradually spreads across the entire surface, flowing and filling in the fine gaps.

Also, the silicone-based resin adhesive contacts the isobutylene-based resin bonding agent while it is crushed, thus gradually undergoing crosslinking reaction to adhesively anchor the substrates as shown in Fig. 3. As a result, the plate crystal element 1 becomes sealed between the glass panel 3 and back side protective substrate 4 through the silicone oil. Furthermore, as shown in Fig. 8, the upper and lower sides of the protruding section of the lead wire 10 become firmly sealed by the silicone-based resin adhesive of the first sealant 6 and the isobutylene-based resin bonding agent of the second sealant 7. When the first sealant 6 is situated on the outside, a method of injecting the silicone-based resin adhesive into the gap between the substrates after lamination may be used. For example, with a laminated body provided with the second sealant 7 at about 5 mm from the outermost periphery, the silicone-based resin may be injected into the gap between the substrate afterwards and subjected to crosslinking reaction to form the first sealant 6. Also, a low viscosity ultraviolet curing adhesive may be injected into the gap and then photoirradiated for adhesive curing.

It is to be noted here that if the provisional laminated body is compressed in a vacuum state at room temperature and the isobutylene-based resin bonding agent is in a firmly contact-bonded state with the substrates, it may be left to stand at atmospheric pressure. The reason for this is that the sealing effect keeps the interior in a vacuum state, and even when left to stand at atmospheric pressure the filler 5 naturally spreads over the entire surface, filling up the minute regions. As a result, the constraint time for expensive vacuum lamination apparatuses is only about 2-3 minutes, thus allowing rapid production and contributing to reduced cost.

However, numerous small gas bubbles will often remain upon lamination. The residual gas bubbles are critical defects for the durability of the solar cell module. Surprisingly, however, even in a laminated body having such numerous residual small gas bubbles, the gas bubbles will gradually reduce in size and completely disappear after being allowed to stand for several days after lamination. According to the invention, it was found that the residual gas bubbles are absorbed by the silicone oil and eventually disappear, such that the difficult problems associated with them are solved. The reason is believed to be that the silicone oil is laminated while it is deaerated under reduced pressure in a vacuum (allowing dissolution of the air), so that the interior is at negative pressure and becomes compressed by atmospheric pressure. It was also found that the negative pressure causes the substrates to be constantly pressed by atmospheric pressure, while the interspersed spacers work effectively to maintain the substrate spacing.

The silicone oil may be situated on both the top and bottom of the plate crystal element 1, or it may be situated on only one side of the plate crystal element 1 since it is able to seep into even minute gaps, and it is sufficient for the necessary amount to be evenly coated onto the substrate. Also, the filler may be dropped after deaerating treatment, or the coating amount increased just above the theoretical amount necessary to fill the gaps, or the approximately equivalent amounts dropped in almost equal gaps (for example, 10 mm, 30 mm, 50 mm pitch) between points, lines or surfaces, or the pressure applied in a gradual stepwise manner, or spacers supplied. Such measures will result in more even spreading of the silicone oil. The order of placement of the sealing compound, plate crystal element 1 and silicone oil may be changed, as it is sufficient if they are properly placed between the substrates before pressing in a vacuum for sealing. Also, by situating the sealing compound on both the top and bottom sides of the protruding section of the lead wire 10 for vacuum compression bonding at the different level of the protruding section of the lead wire 10 as well, it is possible to accomplish reliable sealing in a gas bubble-free state. The order of using the glass panel 3 and back side protective substrate 4 may also be reversed for the provisional laminated body. In order to improve productivity, several provisional laminated bodies may be stacked and placed in the apparatus, for simultaneous vacuum deaeration and simultaneous compression bonding. Since no aluminum frame is necessary, the lead wire protruding from the outer periphery of the substrates can be easily connected with a terminal box even in the case of a large-area module. In addition, the lead wire may extend out from the outer periphery of a hole formed by removing the interior of the back side protective substrate 4 by a conventional method, for connection to a terminal box.

The small module shown in Fig. 3 was fabricated and subjected to a durability test. A polycrystalline plate crystal element 1 having electrodes formed on both sides (25 x 50 x 0.15 mm, product of Kyocera) was prepared, and lead wires made from a thin copper sheet with dimensions 31 x 2 x 0.1 mm were connected (4 mm) to the electrodes with solder. Using a whiteboard glass (90 x 65 x 4 mm) as the glass panel 3, a band-shaped isobutylene-based resin bonding agent (diameter: 2 mm, SM488 by Yokohama Rubber Co., Ltd.) was situated as the second sealant 7 on the inner side thereof at about 2 mm from the edge, and then a room temperature-curing two-pack mixed silicone-based resin adhesive (SE936 by Toray/Dow Corning, Inc.) as the first sealant 6 was coated in a thin-line fashion, leaving a gap of about 1 mm. Also, a dimethylsilicone oil (viscosity: 10,000 CS/25 degrees) as the filler 5 was coated in a square line fashion on the outer periphery leaving a gap of about 5 mm, and two small spots were coated at the center sections. The lead wire-attached plate crystal element 1 was placed at the center section of the coated substrate. The isobutylene-based resin bonding agent and silicone-based resin adhesive were additionally situated on the upper side of the lead wire 10 as well, and after adding two small spots of silicone oil on the plate crystal element 1, a soda-lime glass panel (90 x 65 x 4 mm) was placed as the back side protective substrate 4 to form a provisional laminated body.

The provisional laminated body was placed in a vacuum apparatus, subjected to reduced pressure deaeration for 60 seconds at room temperature (23°C) and then gently compressed, and after contacting the isobutylene-based resin bonding agent with both substrates, the laminated body was allowed to stand at atmospheric pressure. The isobutylene-based resin bonding agent and silicone-based resin adhesive are crushed at the prescribed locations by atmospheric pressure, while the silicone oil gradually develops a flow into the minute regions. The lead wire 10 and both substrates were adhesively bonded by the silicone-based resin adhesive while standing at room temperature. As a result, a gas bubble-free small module was obtained comprising the first sealant 6 with a width of about 4 mm and the second sealant 7 with a width of about 6 mm. The protruding lead wire 10 was also folded into a U-shape and directed back to a measuring terminal (4 mm) on the back side protective substrate 4, and the silicone-based resin adhesive was coated onto the edges of the substrate as an insulating coating on the lead wire, for adhesive bonding of the substrate edges.

Next, the small module was used for a metal halide lamp super UV test (100 mW/cm², EYE SUPER UV TESTER by Iwasaki Electric Co., Ltd.) with 1000 hours of irradiation while standing for 3000 hours at a temperature of 85°C, 85% relative humidity, followed by an ultraharsh durability test with 200 cycles of a temperature cycling test between -20°C and 95°C. Upon measurement using an ordinary tester on the terminal, the value was about 0.425 mV with the lamp light source and about 0.615 mV under sunlight. Surprisingly, measurements before and after the test yielded approximately the same values, indicating high stability. Also, no notable changes were seen upon examining the outer appearance.

A process for producing the module shown in Fig. 1 comprising the thin-film element 8 will now be explained. The sealing structure consists only of a silicone-based resin adhesive as the first sealant 6. Because the thickness of the element is negligibly small at the thin-film element 8, the substrate spacing is very narrow and the bank function of the sealing compound can be easily ensured. Specifically, the silicone-based resin adhesive is situated in a line fashion around the outer periphery of the substrate on which is formed the thin-film element 8 with the lead wire connected by solder. The silicone-based resin adhesive is situated on both the upper and lower sides of the protruding section of the lead wire. In addition, a low viscosity silicone oil as the filler 5 is dropped several times in the form of a square, essentially uniformly across the entire surface along the sealing and glass bead spacers are dispersed thereon, after which the back side protective substrate 4 is laminated thereover to obtain a provisional laminated body.

The provisional laminated body is placed in a vacuum laminating apparatus at room temperature and compressed in stages in a vacuum state. As a result, both substrates become sealed in a short period of time. The sealed laminated body is compressed naturally by atmospheric pressure when exposed to atmospheric pressure, and the silicone-based resin adhesive coated on the outer periphery is further crushed while the silicone oil gradually spreads over the entirety without liquid leakage, filling up into the minute regions. The silicone-based resin adhesive also undergoes crosslinking reaction to adhesively anchor both substrates to form a fast seal.

A process for production of a module with the plate crystal element 1 shown in Fig. 5 will now be explained. Except for placing only the isobutylene-based resin bonding agent of the second sealant 7 around the outer periphery as the sealing compound, the steps are otherwise the same as for the module shown in Fig. 3. However, although the isobutylene-based resin bonding agent has sufficient tack to bond both substrates, it cannot adhesively anchor both substrates. The liquid substance of the filler 5 must therefore be reacted after lamination to form a gel. The reaction may by carried out slowly with moderate heating.

Fig. 7 shows a cross-sectional view of the lead wire 10 protruding from the thin-film element 8 comprising the module shown in Fig. 6. The thin-film element 8 and lead wire 10 are connected by a conductive bonding agent (for example, solder or silver paste) to form a joint 9. The isobutylene-based resin bonding agent of the second sealant 7 bonds to both the upper and lower sides of the protruding section of the lead wire 10, thus preventing liquid leakage of the liquid substance during lamination. The liquid substance is reacted after lamination to form a gel (non-fluid).

The above explanation assumes that the production process is at room temperature, but according to the invention the provisional laminated body may also be heated and sealed in a vacuum, heated after sealing lamination, and subjected to photoirradiation with ultraviolet rays or the like.

The members used according to the invention will now be explained. The glass panel 3 may be any common material that sufficiently transmits light rays, and there may be mentioned whiteboard glass, soda-lime glass and the like. The glass panel may also be processed if necessary, for tempering, surface anti-reflection, templating, ultraviolet ray-blocking or the like. Particularly preferred is surface anti-reflection, to reduce reflection from the interface between air and the filler.

The back side protective substrate 4 may be a member that is commonly used in the prior art, such as for example, a glass panel (for example, soda-lime glass, tempered glass, template glass or the like), a resin sheet (for example, hard polyvinyl chloride, polyester or the like), or a metal or stainless steel sheet. Resin sheets are useful to reduce the weight of the module while the production temperature of the invention may be room temperature, and hard polyvinyl chloride can be utilized for a range of uses from thin sheets of less than 0.1-1 mm (for example, VINYFOIL by Mitsubishi Plastics, Inc.) to thicker sheets of 1-3 mm (for example, POLYMER PANEL by Shin-Etsu Polymer Co., Ltd.). Hard polyvinyl chloride is highly useful because it has good adhesion and cohesion with sealing compounds (for example, silicone-based resin adhesives and isobutylene-based resin bonding agents), while also being weather resistant and economical. Also useful are aluminum foil and ethylenetetrafluoroethylene-laminate sheets, silica-vapor deposited resin sheets (TECHBARRIER LX by Mitsubishi Plastics, Inc.), as well as adhesion-enhanced surface modified sheets. Because thin-film elements are particularly susceptible to moisture, glass panels, aluminum foil laminates and silica-vapor deposited resin sheets are preferred.

As specific examples of liquid substances for the filler 5 there may be mentioned silicone oils, for example, dimethylsilicone oil, methylphenylsilicone oil, methylhydrogensilicone oil, alkyl-modified silicone oil, polyether-modified silicone oil, alcohol-modified silicone oil and the like, or fluorine oils such as fluorinated polyethers, DEMNUM by Daikin Industries, Ltd., and FLUDE by NOK Corp. Ultrafine silica powder or the like may also be added to the liquid substance to impart thixotropy, in order to reduce running and improve the coating performance. This will allow the steps up to substrate cleaning, coating and provisional lamination to be carried out with the substrate in an inclined position, thus helping to reduce contaminant adhesion and facilitating coating and substrate movement, for particular advantages in production of thin-film element modules.

As examples of liquid substances that are liquid at room temperature during lamination but gel by reaction (thermal reaction or photoreaction) after lamination, there may be mentioned silicone-based substances (for example, KE1051 and KE1052 by Shin-Etsu Chemical Co., Ltd., or SE1740, SE1887 and CY52-276 by Toray/Dow Corning, Inc.), modified silicone-based substances (for example, SIFEL8570A/B by Shin-Etsu Chemical Co., Ltd.) and the like, which form ultrahigh durability silicone gels and are thus useful for the invention. According to the invention, incidentally, these silicone-based or modified silicone-based liquid substances will be collectively referred to as "silicone-based liquid substances".

Also, an ultraviolet absorber (for example, benzophenone-based, benzotriazole-based, triazine-based or the like) may be added to the liquid substance to improve the weather resistance, and ultraviolet ray blocking with the filler 5 can also help protect a resin sheet used as the back side protective substrate 4. Examples of useful ultraviolet absorbers include SEESORB-103 by Shipro Kasei Co., Ltd. and TINUVIN328 and TINUVIN400 by Ciba Specialty Chemicals Co., Ltd.. The amount may be 0.1-5 W%, preferably about 0.2-3 W% and more preferably about 0.5-2 W%. Methylphenylsilicone oil (for example, SH550, SH702 or SH705 by Toray/Dow Corning, Inc.), in particular, facilitates dissolution of the ultraviolet absorber by the effect of the phenyl groups. For further enhanced solubility, fillers may be used in admixture, or functional groups with affinity for the filler may be introduced into the ultraviolet absorber (to produce a substance with the ultraviolet absorber bonded to modified silicone, for example). A low solubility substance may also be evenly dispersed as ultrafine particles.

The sealing compound includes the crosslinking reactive adhesive used for the first sealant 6 and the hot-melt adhesive used for the second sealant 7. These substances undergo flow deformation under pressure at room temperature. Crosslinking reactive adhesives include two-pack mixed crosslinking reactive adhesives, one-pack crosslinking reactive adhesives that react with water molecules, and crosslinking reactive adhesives that react by ultraviolet irradiation. The viscosity is preferably the high viscosity of a paste, which allows extrusion coating while resisting deformation by its own weight. Highly weather resistant silicone-based resin adhesives are most particularly useful for the invention because of their satisfactory adhesion with glass panels, and they may be used with both one-pack and two-pack mixing types. Examples thereof include dealcoholized silicone-based resin adhesives (for example, SE9155, SE9175, SE737, SE9500 or SE936 by Toray/Dow Corning, Inc., KE4866 or KE4898 by Shin-Etsu Chemical Co., Ltd., and TSE392-C by Momentive Performance Materials, Inc.), deacetonized silicone-based resin adhesives (for example, KE348 or KE3428 by Shin-Etsu Chemical Co., Ltd.), modified silicone-based resin adhesives (for example, SUPER-X by Cemedine Co., Ltd. and SIFEL2000 by Shin-Etsu Chemical Co., Ltd.), and silicone reactive hot-melt adhesives (for example, InstantGlaze by Dow Corning). Silicone-based resin adhesives are known and will not be described here. There may also be used sulfide-based, urethane-based, acrylic-based, isobutylene-based, acrylurethane-based, epoxy-based and acrylepoxy-based compounds, although their weather resistance is inferior to silicone-based compounds.

Naturally, fillers (for example, silica powder, ultrafine silica powder, calcium carbonate and the like), antioxidants, ultraviolet absorbers, plasticizers, lubricants, pigments, drip preventers and reaction modifies may be added as necessary. The additives in both the first sealant 6 and second sealant 7 must be selected with consideration of the insulating property.

The viscosity of the crosslinking reactive adhesive may be higher than, preferably at least twice and more preferably at least 10 times that of the liquid substance of the filler 5, in order to facilitate placement at the prescribed position. Particularly when sealing is formed at the outer periphery of the crosslinking reactive adhesive alone, the viscosity may be adjusted by a method of increasing the viscosity by imparting thixotropy (to prevent deformation under its own weight) (by addition of ultrafine silica powder, for example), a method of increasing the viscosity by light reaction after coating (with a silicone-based resin adhesive, for example), or a method of heating to increase the flow property and facilitate application (with a silicone reactive hot-melt adhesive, for example). Since the silicone reactive hot-melt adhesive has both an adhesive and a bank function, it is relatively resistant to moisture and is therefore particularly useful for modules of the plate crystal element 1 which have large spacings between the substrates. Considering the fact that it is in prolonged contact with the liquid substance of the filler 5, the silicone-based resin adhesive may be placed on the inside, as the first sealant 6 in Fig. 2 and Fig. 3, because the silicone-based resin adhesive has higher chemical stability than the isobutylene-based resin bonding agent. For example, the silicone-based resin adhesive is stable without any particular alterations even when contacted with silicone oil, silicone gel, fluorine oil or the like.

The hot-melt adhesive may be, for example, an isobutylene-based resin. These may be heated and continuously extruded in the form of a band (cross-section: circular, semicircular, elliptical, rectangular, etc.) for easy plastic deformation under pressure at room temperature without undergoing deformation under their own weight at room temperature. An isobutylene-based resin bonding agent will be explained as a representative example. Isobutylene-based resins are composed entirely of hydrocarbons having an isobutylene unit as the basic structure, as described in detail in the chapter entitled "Butyl Rubber/Polyisobutylene Adhesives" of Encyclopedia of Adhesives by Asakura Publishing (Handbook of Adhesives/Third Edition, Van Nostrad Reinhold Publishing). This resin has extremely low water vapor transmittance due to the methyl group effects, and hydrophobicity. Because it is an amorphous polymer, moreover, it exhibits excellent flexibility, impact resistance and durable tack. The glass transition temperature is near -60°C, and therefore it can maintain flexibility and exhibit high adhesiveness at low temperatures below room temperature. More specifically, polyisobutylene and isobutylene-isoprene copolymer may be used as mixtures with tackifiers (for example, epoxy resins, silane coupling agents, alkyl titanates, etc.), insulating fillers (for example, silica powder, ultrafine silica powder, etc.), antioxidants, ultraviolet absorbers, plasticizers, lubricants, pigments and the like, when necessary. The isobutylene-based resin bonding agent has high weather resistance and low permeability for moisture and oxygen, and is therefore useful for a solar cell module of the invention that is to be used outdoors. Even when both substrates are glass panels, an isobutylene-based resin bonding agent is highly useful to prevent diffusion of moisture from the cross-section of the substrate outer periphery to the interior. Naturally, a sealed structure that simultaneously employs a silicone-based resin adhesive instead of this resin alone is also preferred when the filler is a non-fluid gel, in order to ensure adhesiveness (moisture-proofness) for prolonged periods.

While not shown here, spacers may be used if necessary to guarantee the spacing between the substrates, and their form may be as beads, rods, sheets or the like, with the sizes appropriately selected according to the site of use (for example, at the filler sections or at the sealing sections). The placement of the spacers may be anchored at prescribed spacings, or they may be randomly dispersed and non-anchored. The spacers may also be added beforehand to the filler and coated with it. The material may be freely selected from among glass, ceramic, resin, rubber, metals and the like.

As explained above, the present inventors found that in order to obtain a solar cell module for semi-permanent use, it is essential for at least the transparent substrate, solar cell element and filler to be made of ultrahigh durability materials. Focusing on the use of high durability liquid substances as fillers, we established a production process whereby a liquid substance is sealed in a gas bubble-free state at room temperature in a vacuum. As a result, a high durability module comprising a liquid substance sealed by a fast sealed structure was obtained. The high durability is highly significant in terms of energy recovery, resource saving and economy. Needless to mention, it was possible to obtain a module with absolutely no gas bubbles (critical defects in electrical components) or liquid leakage (defective modules). High-speed production at room temperature is also possible, thus greatly contributing to reduced cost and lowering production energy. In addition, since the sealing compound and liquid substance are directly coated onto the substrates, the method can be applied for modules of different shapes and sizes including very large sizes, and is suitable for continuous mass production. Furthermore, since high moisture proofness and high durability can be ensured without providing an aluminum frame on the module, it is economical and also resistant to lightning strikes. Thus, the present invention is highly useful for solar photovoltaic power generation that employs very large sized modules on a large scale. Moreover, its semi-permanent durability is of great economical advantage from the viewpoint of replacement cost, considering that installation is on roofs in urban areas, and since the expensive crystal element can be easily removed from the substrate, the recyclability is also excellent. Furthermore, it is possible to maintain low internal stress in the module of the invention even when it is subject to large temperature differences, because the filler 5 is a liquid substance or flexible gel. The invention is therefore effective for preventing element damage, interfacial peeling, electrode peeling and the like in elements that are expected to be practical in the future, such as ultrathin plate crystal elements, high-conversion-rate heterostructure elements and multi-joint elements.

### Industrial Applicability

The present invention can provide ultrahigh durability solar cell modules at low cost, and is therefore highly useful for industry.

## Claims

1. A solar cell module having a photoelectric conversion thin-film element or crystal element situated between a transparent substrate and a back side protective substrate, with a filler situated surrounding the element and the outer periphery sealed with a sealing compound, the solar cell module being **characterized in that** the transparent substrate is a glass panel, the filler is a silicone-based liquid substance, fluorine oil or silicone gel, the sealing compound is composed of a crosslinking reactive adhesive, both substrates are adhesively anchored in contact with the outer periphery of the filler, the sections of the lead wires that protrude from the element, which penetrate the sealing compound on the outer periphery, are bonded with the sealing compound and are adhesively anchored between both substrates, and the filler and element are sealed between both substrates together with the sealing compound.

2. A solar cell module according to claim 1, wherein the crosslinking reactive adhesive is a silicone-based resin adhesive.

3. A solar cell module according to claim 1 or 2, wherein the isobutylene-based resin bonding agent is formed at the outer periphery between the substrates in such a manner that it contacts the crosslinking reactive adhesive.

4. A process for production of a solar cell module according to claim 1, the process being **characterized in that** a photoelectric conversion thin-film element or crystal element is situated on either a glass panel or a back side protective substrate, a crosslinking reactive adhesive is situated as a sealing compound at the outer periphery sections of the lead wires extending from the outer periphery of the substrate and the element, a silicone-based liquid substance or fluorine oil is situated as a filler, another glass panel or back side protective substrate is laminated thereover, the filler and element are pressure laminated between both substrates in a vacuum state together with the crosslinking reactive adhesive situated around their outer periphery, to form a laminated body, and then the crosslinking reactive adhesive is crosslinked.

5. A process for production of a solar cell module according to claim 4 above, wherein the laminated body is formed by pressure lamination after placing an isobutylene-based resin bonding agent adjacent to the crosslinking reactive adhesive, to additionally form an isobutylene-based resin bonding agent layer between the substrates.

6. A process for production of a solar cell module according to claim 4 or 5, wherein after lamination a silicone-based liquid substance is reacted to form a silicone gel.

7. A solar cell module having a photoelectric conversion crystal element situated between a transparent substrate and a back side protective substrate, with a filler situated surrounding the element and the outer periphery sealed with a sealing compound, the solar cell module being **characterized in that** the transparent substrate is a glass panel, the filler is a silicone gel, the sealing compound is composed of an isobutylene-based resin bonding agent, both substrates are adhesively anchored in contact with the outer periphery of the filler, the sections of the lead wires that protrude from the element, which penetrate the sealing compound on the outer periphery, are bonded with the sealing compound and are adhesively anchored between both substrates, and the filler and element are sealed between both substrates together with the sealing compound.

8. A process for production of a solar cell module according to claim 7, the process being **characterized in that** a crystal element is situated on either a glass panel or a back side protective substrate, an isobutylene-based resin bonding agent is situated as a sealing compound at the outer periphery sections of the lead wires extending from the outer periphery of the substrate and the element, a silicone-based liquid substance is situated as a filler, another glass panel or back side protective substrate is laminated thereover, the filler and element are pressure laminated between both substrates in a vacuum state together with the isobutylene-based resin bonding agent around their outer periphery, to form a laminated body, and then the silicone-based liquid substance is reacted to form a silicone gel.

9. A solar cell module having a photoelectric conversion thin-film element situated between a transparent substrate and a back side protective substrate, with a filler situated surrounding the element and the outer periphery sealed with a sealing compound, the solar cell module being **characterized in that** the transparent substrate is a glass panel, the filler is a silicone gel, the sealing compound is composed of an isobutylene-based resin bonding agent, both substrates are adhesively anchored in contact with the outer periphery of the filler, the sections of the lead wires that protrude from the element, which penetrate the sealing compound on the outer periphery, are bonded with the sealing compound and are adhesively anchored between both substrates, and the filler and element are sealed between both substrates together with the sealing compound.

10. A process for production of a solar cell module according to claim 9, the process being **characterized in that** an isobutylene-based resin bonding agent is situated as a sealing compound at the outer periphery sections of the lead wires extending from the outer periphery of a glass panel on which a photoelectric conversion thin-film element is formed, and the element, while a silicone-based liquid substance is situated as a filler, a back side protective substrate is laminated thereover, the filler and element are pressure laminated between both substrates in a vacuum state together with the isobutylene-based resin bonding agent around their outer periphery, to form a laminated body, and then the silicone-based liquid substance is reacted to form a silicone gel.
